# DEMANDE DE BREVET EUROPEEN

(11) **EP 4 579 728 A1**
(43) Date de publication de la demande: **02.07.2025**
(21) Numéro de dépôt: 24221996.2
(22) Date de dépôt: 20.12.2024
(51) Int. Cl.: H01L 23/00, H01L 21/20, H01L 21/78, H01L 21/306, H01L 21/683

(54) **PROCEDE DE FORMATION DE ZONES HYDROPHOBES SUR UN SUBSTRAT**

(30) Priorité: 26.12.2023 FR 2315316
(71) Demandeur: Commissariat à l'Energie Atomique et aux Energies Alternatives, 75015 Paris (FR)
(72) Inventeur: FOURNEL, Franck, 38054 GRENOBLE CEDEX 09 (FR); MONTMEAT, Pierre, 38054 GRENOBLE CEDEX 09 (FR); ENOT, Thierry, 38054 GRENOBLE CEDEX 09 (FR)
(74) Mandataire: Cabinet Beaumont

(57) **Abrégé**

La présente description concerne un procédé de formation de zones hydrophobes comprenant les étapes suivantes :
- fournir une structure comprenant un substrat d'intérêt (200) collé à un substrat temporaire (100), le substrat temporaire (100) comprenant un substrat de base (110) recouvert localement de plots (120) et d'éléments en relief (130, 140) ayant une hauteur inférieure à la hauteur des plots (120), les éléments en relief (130, 140) entourant les plots (120) et se prolongeant jusqu'au bord du substrat temporaire (200), des interstices séparant le substrat d'intérêt (200) des éléments en relief (130, 140),
- mettre en contact la structure avec une solution (300) comprenant un composé hydrophobe ou un agent de gravure, moyennant quoi la solution (300) s'infiltre dans les interstices et des zones hydrophobes sont formées sur le substrat d'intérêt (200) en regard des éléments en relief (130, 140).

## Description

### Domaine technique

La présente description concerne de façon générale le domaine de la microélectronique, et plus particulièrement, les substrats pour les collages de type puces à plaques.

### Technique antérieure

Dans le cadre du collage de type puces à plaques, les puces doivent être positionnées sur une plaque en des zones prédéfinies. Pour faciliter le positionnement des puces, il est possible de créer, sur les plaques, des zones hydrophiles entourées de zones hydrophobes. Les puces, amenées avec un liquide (typiquement de l'eau), se placeront alors spontanément sur les zones hydrophiles.

Pour former des zones hydrophobes autour de zones hydrophiles sur une plaque, il est courant de coller une plaque ayant une surface hydrophile avec une plaque temporaire recouverte de plots. Les plots protègent les zones sur lesquelles les puces seront ultérieurement positionnées. La structure ainsi obtenue est ensuite mise en contact, par immersion par exemple, avec un liquide pouvant rendre la surface de la plaque hydrophobe. L'objectif est de propager le liquide autour des plots pour rendre la surface autour des plots hydrophobes. La partie positionnée sous les plots n'est pas en contact avec le liquide et reste hydrophile.

Cependant, dans certains cas, cette pénétration est assez lente et des bulles d'air peuvent se retrouver emprisonnées entre les deux plaques, ce qui empêche la propagation du liquide et conduit à des zones qui demeurent hydrophiles au lieu de devenir hydrophobes, ce qui est particulièrement gênant pour le positionnement des puces.

### Résumé de l'invention

Il existe un besoin d'avoir un procédé permettant de créer des zones hydrophobes autour de zones hydrophiles, de façon fiable.

Ce but est atteint par un procédé de formation de zones hydrophobes sur un substrat d'intérêt, le procédé comprenant les étapes suivantes :
- fournir le substrat d'intérêt comprenant une première surface hydrophile et un substrat temporaire comprenant un substrat de base recouvert localement de plots et d'éléments en relief ayant une hauteur inférieure à la hauteur des plots, une première partie des éléments en relief étant des éléments périphériques entourant les plots et une deuxième partie des éléments en relief étant des éléments de connexion fluidique allant des éléments périphériques jusqu'au bord du substrat temporaire,
- coller les plots du substrat temporaire sur la première surface hydrophile du substrat d'intérêt, moyennant quoi le substrat d'intérêt est séparé des éléments en relief par des interstices,
- mettre en contact le substrat d'intérêt avec une solution comprenant un composé hydrophobe ou un agent de gravure, moyennant quoi la solution s'infiltre dans les interstices et des zones hydrophobes sont formées sur le substrat d'intérêt en regard des éléments en relief.

Avantageusement, les éléments en relief ont une hauteur représentant moins de 50% et, de préférence, moins de 10% de la hauteur des plots.

Avantageusement, les interstices ont une hauteur comprise entre 0,1 et 10 µm, de préférence entre 1 et 5 µm.

Avantageusement, les plots ont une hauteur comprise entre 10 et 100 µm.

Avantageusement, les éléments de connexion fluidique forment un pourtour sur le substrat de base.

Avantageusement, les éléments de connexion fluidique sont positionnés de manière discontinue sur le pourtour du substrat de base, de manière à former des évents entre les éléments de connexion fluidique.

Avantageusement, les éléments en relief ont une largeur comprise entre 10 µm et 2,5 mm.

Avantageusement, les plots ont une surface comprise entre 0,25 et 400 mm².

Avantageusement, le substrat comprend des zones de plus fortes topographies et/ou d'interconnexions métalliques, sur lesquelles sont collés les plots.

Avantageusement, seul un bord du substrat d'intérêt est mis en contact avec la solution, au niveau d'un élément de connexion fluidique.

Ce but est également atteint par un substrat ayant une première surface comprenant des zones hydrophiles entourées par des zones hydrophobes, ayant de préférence une largeur comprise entre 10 µm et 2,5 mm, des lignes hydrophobes reliant les zones hydrophobes au bord du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D et la figure 1E représentent de manière schématique différentes étapes d'un procédé de fabrication d'un substrat d'intérêt recouvert par des zones hydrophobes ;
la figure 2 et la figure 3 représentent, de manière schématique et en vue de dessus, un substrat d'intérêt selon différents modes de réalisation particuliers de l'invention ;
la figure 4A, la figure 4B, la figure 4C, la figure 4D, la figure 4E, la figure 4F et la figure 4G représentent, de manière schématique différentes étapes d'un procédé de fabrication d'un substrat temporaire selon un mode de réalisation particulier de l'invention.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Même si la description fait particulièrement référence à des substrats pour des collages de type puces à plaque, le procédé est particulièrement intéressant pour toutes les applications nécessitant de propager un liquide autour de plots sur une certaine largeur ou à des endroits spécifiques sans forcément mouiller l'ensemble de l'espace libre entre les plaques.

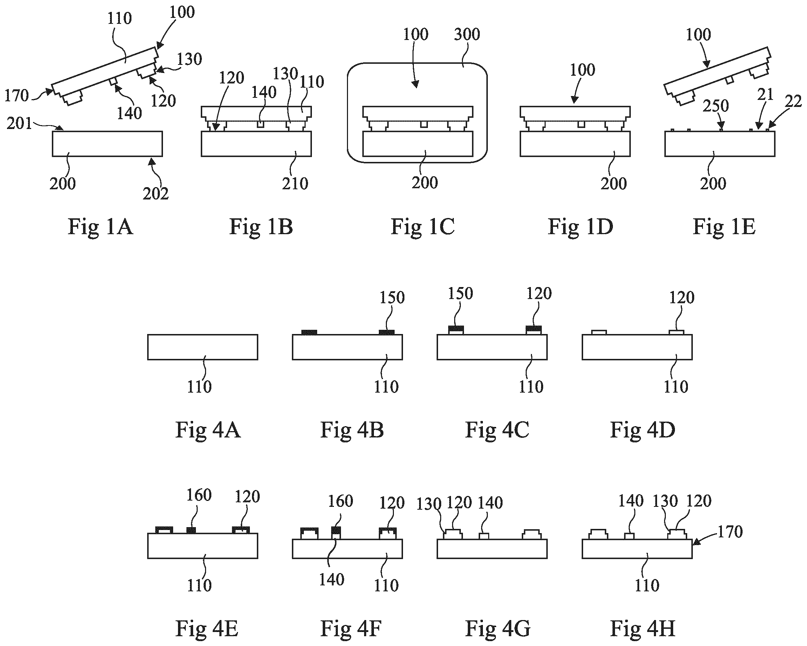

Nous allons maintenant décrire plus en détail le procédé de formation de zones hydrophiles Z1 entourées de zones hydrophobes Z2 sur un substrat d'intérêt 200 en faisant référence aux figures 1A, 1B, 1C, 1D et 1E.

Le procédé comprend les étapes suivantes :
a) fournir le substrat d'intérêt 200 et un substrat temporaire 100, le substrat d'intérêt 200 ayant une première surface 201 hydrophile et une deuxième surface 202, le substrat temporaire 100 comprenant un substrat de base 110 présentant localement en surface des plots 120 et des éléments en relief 130, 140 ayant une hauteur inférieure à la hauteur des plots 120, une première partie des éléments en relief correspondant à des éléments dits périphériques 130 entourant les plots 120, une deuxième partie des éléments en relief correspondant à des éléments dits de connexion fluidique 140 allant des éléments périphériques 130 jusqu'au bord du substrat temporaire 200, (figure 1A),
b) coller le substrat temporaire 100 sur la première surface 201 du substrat d'intérêt 200, et plus particulièrement coller les plots 120 du substrat temporaire 100 sur la première surface 201 du substrat d'intérêt 200, le substrat d'intérêt 200 étant séparé des éléments en relief 130, 140 par des interstices (figure 1B),
c) mettre la structure, obtenue à l'étape b), en contact avec une solution 300 comprenant un composé permettant de rendre la surface 201 du substrat d'intérêt 200 hydrophobe, moyennant quoi la solution 300 s'infiltre dans les interstices et des zones hydrophobes Z2, Z3 sont formées sur la première surface 201 du substrat d'intérêt 200 en regard des éléments en relief 130, 140 (figures 1C, 2 et 3),
d) de préférence, nettoyer le substrat (figure 1D),
e) séparer le substrat temporaire 100 et le substrat d'intérêt 200 (figure 1E).

Entre les deux substrats 100, 200, il y a plusieurs types d'espacement (ou gap) différents :
- des interstices (zones de petits gaps) entre le substrat d'intérêt 200 et les éléments en relief 130, 140,
- des espaces (zones de grands gaps) entre le substrat d'intérêt 200 et le substrat de base 110 du substrat temporaire 100.

Les interstices ont une hauteur représentant moins de 50% et, de préférence, moins de 10% de la hauteur des zones de grands gaps.

Les interstices ayant une très faible hauteur par rapport à la hauteur des espaces entre le substrat d'intérêt 200 et le substrat de base 110 du substrat temporaire 100, le mouillage se fera préférentiellement au niveau des interstices (i.e. entre les deux surfaces séparées par le plus petit espacement) car les forces capillaires seront les plus fortes à ce niveau.

Un tel procédé permet de propager efficacement le liquide entre les plots 120 de deux plaques collées l'une à l'autre.

Avec un tel procédé, il est possible d'obtenir un mouillage partiel et d'augmenter la cinétique de mouillage en jouant sur la hauteur des interstices.

Le substrat d'intérêt 200 est, de préférence, une plaque.

Le substrat d'intérêt 200 est, par exemple, un substrat en matériau semiconducteur (de préférence, Si, Ge, SiC, AsGa), en saphir ou en silice.

Le substrat d'intérêt 200 fourni à l'étape a) peut être un substrat SOI ('Silicon on Insulator'), c'est-à-dire comprenant un substrat support recouvert successivement par une fine couche d'oxyde enterré et une couche de silicium.

Alternativement, il peut s'agir d'un substrat massif en matériau semiconducteur (silicium par exemple) recouvert d'une couche diélectrique, en particulier une couche d'oxyde (oxyde de silicium notamment).

Le substrat d'intérêt 200 a une première surface 201 et une deuxième surface 202. La première surface 201 est une surface hydrophile.

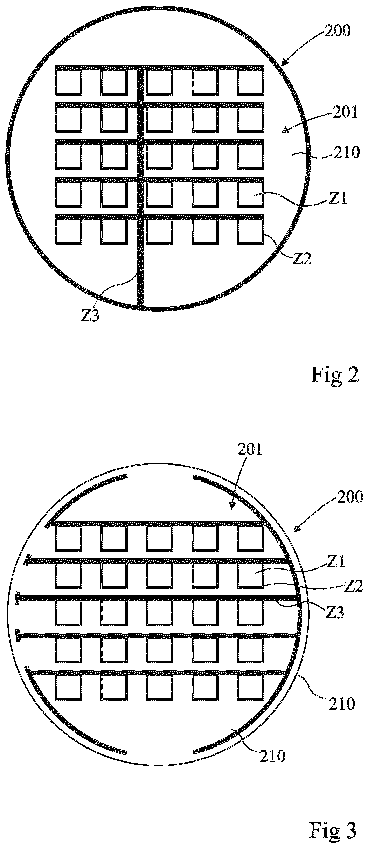

La première surface 201 comprend des premières zones Z1 que l'on souhaite maintenir hydrophile et des deuxièmes zones Z2 entourant les premières zones que l'on souhaite rendre hydrophobe (figures 2 et 3). Les premières zones Z1 seront protégées par les plots 120 du substrat temporaire 100 après le collage de l'étape b).

Les premières zones Z1 peuvent être des zones de plus fortes topographies et/ou des zones d'interconnexions métalliques destinées à être connectées à des puces. Par forte topographie, on entend que les premières zones Z1 dépassent d'au moins 100nm et plus particulièrement de 500 nm voir de 1 µm de la surface du substrat.

Les premières zones Z1 peuvent être disposées régulièrement ou de manière non régulière. Elles peuvent être de même dimension ou de dimensions différentes.

Le substrat temporaire 100 comprend le substrat de base 110, les plots 120 (piliers ou colonnes) et les éléments en relief 130, 140.

La base des plots 120 peut être de différentes formes. Elle peut être carrée, rectangulaire ou encore circulaire.

La solution 300 étant amenée jusqu'aux zones à rendre hydrophobe grâce aux interstices, les plots 120 peuvent être espacés par de faibles distances ou par des distances plus importantes. L'espacement des plots 120 sera choisi en fonction de l'application voulue. Les plots 120 sont, par exemple, espacés de plus de 10 µm voire de plus de 50 µm ou moins. Ils peuvent aussi être espacés de quelques millimètres.

Les éléments en relief 130, 140 ont une hauteur inférieure à la hauteur des plots 120. Les différents éléments en relief 130, 140 peuvent avoir des hauteurs identiques ou différentes. De préférence, les hauteurs sont identiques ou sensiblement identiques.

Les éléments en relief 130, 140 ont, de préférence, une largeur comprise entre 10 µm et 2,5 mm.

Une première partie des éléments en relief correspond à des éléments dits périphériques 130 positionnés autour des plots 120. Ils forment la partie périphérique des plots 120. Lors du collage, la partie du substrat d'intérêt 200 disposée en regard des éléments périphériques 130 correspond aux zones Z2 que l'on souhaite rendre hydrophobes.

Une deuxième partie des éléments en relief correspond à des éléments dits de connexion fluidique 140 permettant de relier les éléments périphériques 130 positionnés autour des plots 120 au bord du substrat. Lors du collage, les interstices formés en regard de ces éléments forment des chemins ou canaux d'écoulement de la solution qui débouchent au bord du substrat d'intérêt 200.

Chaque élément périphérique 130 est relié au bord du substrat au moyen d'un élément de connexion fluidique 140. Un élément de connexion fluidique 140 peut permettre de relier plusieurs éléments périphériques 130 au bord du substrat.

Les éléments de connexion de fluidique 140 sont, par exemple, agencés en ligne au centre du substrat de base 110.

Les éléments en relief peuvent en outre recouvrir une partie ou la totalité du pourtour du substrat de base 110.

Selon une première variante, les éléments en relief recouvrent la totalité du pourtour du substrat de base 110.

Selon une autre variante, les éléments en relief recouvrent uniquement une partie du pourtour du substrat de base 110. Ceci permet de créer un ou plusieurs évents pour permettre, le cas échéant, à l'air chassé par l'entrée de la solution 300 de s'échapper.

La base 110, les plots 120 et les éléments en relief 130 peuvent être en des matériaux différents. De préférence, ils sont en un même matériau. Il peut s'agir d'un métal ou d'un matériau semi-conducteur par exemple. De préférence, il est en silicium.

Le substrat temporaire 100 est, de préférence, obtenu à partir d'un substrat massif.

Notamment, le substrat temporaire 100 peut être fabriqué avec des étapes de photolithographie. A titre illustratif, comme représenté sur les figures 4A à 4H, le substrat peut être fabriqué selon les étapes suivantes :
- fournir un substrat 110 (figure 4A),
- déposer localement une résine 150 sur le substrat 110 (figure 4B),
- graver les parties du substrat non recouvertes par la résine 150 pour délimiter la partie supérieure des plots 120 (figure 4C),
- retirer la résine 150 (figure 4D),
- déposer une résine additionnelle 160, d'une part, sur le dessus et sur les flancs de la partie supérieure des plots 120, pour pouvoir finaliser la formation des plots 120 et pour pouvoir former les éléments périphériques 130 entourant les plots, et d'autre part, localement sur le substrat 110 au droit des futures zones des éléments de connexion fluidique 140 (figure 4E),
- graver le substrat 110 pour former les plots 120 et les éléments en relief 130, 140 (figure 4F),
- retirer la résine additionnelle 160 (figure 4G),
- éventuellement, détourer le substrat 110 (figure 4H).

Le détourage du bord de plaque 110 permet d'éviter un éventuel contact en bord entre le substrat temporaire 100 et le substrat d'intérêt 200, notamment si le plot 120 n'est pas très épais.

Le détourage peut être réalisé, par exemple, par photolithographie/gravure ou encore par détourage mécanique au moyen d'une scie diamantée. La largeur du détourage, dans le plan du substrat, est comprise, par exemple, entre 1 et 5 mm et/ou sa profondeur, dans un plan perpendiculaire à celui du substrat, comprise, par exemple, entre 100 et 250 µm.

Préalablement à l'étape b), il est possible de réaliser un ou plusieurs pré-traitements sur la surface du substrat temporaire 100 et/ou sur la surface du substrat d'intérêt 200 de façon à les rendre compatible avec un collage direct.

Le pré-traitement peut être choisi parmi les pré-traitements suivants : recuit thermique, plasma, polissage et nettoyage humide.

A titre d'exemple, il est possible de former une couche d'oxyde à la surface du substrat temporaire 100 et/ou de réaliser une étape de polissage sur le substrat temporaire 100 et/ou sur le substrat d'intérêt 200 pour obtenir une rugosité compatible avec un collage direct (typiquement une rugosité inférieure à 0,5 nm RMS). Il est possible de mettre en oeuvre des procédés qui combinent, par exemple, un plasma et une solution aqueuse, notamment un plasma oxygène suivi d'un nettoyage humide CARO (H₂SO₄, H₂O₂ en proportion 5 :1) associé avec SC1 (H₂O, NH₃, H₂O₂ en proportion 5 :1 :1).

Lors de l'étape b), le substrat temporaire 100 et le substrat d'intérêt 200 sont collés.

Les deux substrats 100, 200 peuvent être assemblés par collage direct. L'utilisation de marques sur les substrats 100, 200 peut faciliter leur alignement. Une précision d'environ 100 nm peut être atteinte. Il est également possible de les aligner, sans avoir recours aux marques, en utilisant les bords des substrats ainsi que leur encoche (ou 'notch'). La précision est moindre (+/- 50 pm) mais suffisante pour certaines applications.

Le collage direct peut être réalisé à la pression atmosphérique (soit 1013,25 hPa) ou sous vide. L'assemblage n'a pas forcément besoin d'être consolidé par un traitement thermique. Néanmoins, un recuit, à une température de préférence inférieure à 200°C, peut être avantageusement réalisé. Il est possible de recuire à plus haute température mais il y a un risque d'abîmer les surfaces lors du décollement final entre les deux substrats 100 et 200.

Lors du collage, les plots 120 du substrat temporaire 100 sont collés sur la première surface 201 du substrat d'intérêt 200, et plus particulièrement sur les premières zones hydrophiles Z1 du substrat 200 que l'on souhaite protéger lors de l'étape c). Les éléments en relief périphériques 130 autour des plots 120 sont positionnés en regard des deuxièmes zones Z2 du substrat 100 que l'on souhaite rendre hydrophobes (figures 2 et 3).

Lors du collage, la hauteur des espaces entre les substrats 110, 200 (zones de grand gap) varie, par exemple, entre 10 µm et 100 µm. La hauteur des zones de grand gap peut être constante au sein d'un même assemblage, mais elle peut aussi varier légèrement (typiquement de moins de 10%).

Le collage conduit à la formation d'interstices entre la première surface 201 du substrat d'intérêt 200 et les éléments en relief 130, 140 du substrat temporaire 100. L'épaisseur (ou hauteur) des interstices varie, par exemple, entre 0,1µm et 10µm, de préférence, entre 1 µm et 5 µm.

La hauteur des zones de petits gaps est en général constante sur la plaque à 10% près mais elle peut aussi intentionnellement varier. Cela peut être intéressant pour avoir des cinétiques de mouillage différentes suivant la localisation sur la plaque.

Un premier groupe d'interstices est formé entre les éléments en relief périphérique 130 et le substrat d'intérêt 200. L'épaisseur (ou hauteur) des interstices correspond à la différence de hauteur entre les plots 120 et les éléments en relief périphérique 130.

Un deuxième groupe d'interstices est formé entre la première surface 210 du substrat 200 et les éléments en relief de connexion fluidique 140. Ces interstices forment ainsi des chemins privilégiés pour le liquide (étape c)). L'épaisseur de ces interstices dépend de la différence de hauteur entre les plots 120 et les éléments en relief de connexion fluidique 140.

La structure comprend un ou plusieurs chemins pour guider la solution 300 depuis l'extérieur des substrats jusqu'aux zones Z2 à rendre hydrophobe. Les zones Z3 du substrat d'intérêt 200 positionnées sous ces chemins de circulation de la solution 300 seront également hydrophobes à l'issue du procédé (figures 2 et 3).

Lors de l'étape c), le substrat d'intérêt 200 est mis en contact avec une solution 300. La solution 300 est une solution permettant de rendre la surface hydrophobe. C'est en général une solution comprenant des composés hydrophobes qui viennent localement se fixer sur la surface du substrat d'intérêt 200 pour le rendre localement hydrophobe. Il est possible également de rendre la surface hydrophobe en réalisant une gravure, notamment d'une couche superficielle pour mettre à nu un matériau hydrophobe sous-jacent.

Le substrat d'intérêt 200 peut être mis en contact avec la solution 300 par immersion totale ou partielle ou encore par insertion ou injection de la solution 300 dans les interstices formés lors du collage. De préférence, seul un bord du substrat d'intérêt est mis en contact avec la solution 300.

La solution 300 s'infiltre dans les interstices positionnés sous les éléments en relief de connexion fluidique 140 jusqu'aux zones Z2 positionnées sous les éléments en relief périphériques 130.

La pénétration de la solution au travers des chemins étroits est rendue possible par les forces capillaires. Comme cela est présenté sur les figures 2 et 3, lorsque l'arrivée de la solution se situe au niveau du bord d'une terminaison de chemin, les forces capillaires vont spontanément permettre à la solution de combler l'ensemble des chemins sans qu'il soit nécessaire d'immerger entièrement l'assemblage. On évite ainsi une contamination des deux faces extérieures de l'assemblage par la solution.

Le détourage facilite l'entrée du liquide au bord des structures collées.

Dans une première variante, la surface du substrat 200 en contact avec la solution devient hydrophobe suite à la formation d'une couche hydrophobe 250 au niveau des interstices (figure 1E).

Le choix de la couche hydrophobe 250 dépendra, notamment, du substrat d'intérêt 200.

La couche hydrophobe obtenue 250 a, par exemple, une épaisseur comprise entre 2 nm et 100 nm.

La couche hydrophobe 250 peut être obtenue à partir d'un polymère, d'un silyle (aussi appelés organo-silylés) ou d'un silane.

Le composé hydrophobe choisi comprend, de préférence, un ou plusieurs groupes halogènes, notamment des groupes fluor ou chlore. De préférence, le composé hydrophobe comprend une chaîne carbonée d'au moins 5 atomes de carbone.

Le silane peut être un chlorosilane comme l'octadécyltrichlorosilane (OTS = CH₃(-CH₂)₁₇-SiCl₃) commercialisé par la société Sigma Aldrich.

Les polymères peuvent être des polymères fluorés comme par exemple le polymère Novec^{™} 1720 EGC commercialisé par la société 3M^{™}, l'Optool commercialisé par la société DAIKIN et le polymère Novec^{™} 2202 EGC commercialisé par la société 3M^{™}. Le composé hydrophobe peut être choisi parmi les chlorosilanes comme le perfluorodecyltrichlorosilane (FDTS = Cl₃Si(CH₂)₂(CF₂)₇CF₃) commercialisé par la société Sigma-Aldrich, le perfluorodecyldimethylchlorosilane (FDDMCS = CF₃(CF₂)₇(CH₂)₂(CH₃)₂SiCl) commercialisé par la société Sigma-Aldrich.

En variante, la surface du substrat 200 en contact avec la solution peut devenir hydrophobe par gravure locale sélective de la couche de surface du substrat 200 mettant à nu localement un matériau hydrophobe du substrat 200.

Par exemple, si la surface du substrat 200 est en silicium, il est possible de la rendre hydrophobe en gravant la couche d'oxyde natif présente en surface du silicium par de l'acide fluoridrique (HF), par exemple avec une solution contenant 1% de HF.

Après l'étape c), une étape d) de nettoyage au moyen d'un rinçage et, éventuellement, une étape de séchage peuvent être réalisées. Le séchage peut être réalisé par centrifugation.

Un recuit peut permettre de sécher et/ou stabiliser la couche hydrophobe 250.

Lors de l'étape e), le substrat temporaire 100 est séparé du substrat d'intérêt 200. L'assemblage peut être démonté en insérant par exemple un coin entre les deux substrats 100, 200.

Le substrat temporaire 100 peut être utilisé dans un nouveau cycle de collage/gravure. Un nettoyage est, avantageusement, réalisé entre chaque utilisation.

Par exemple, il est possible de le recycler en mettant en oeuvre un traitement plasma oxygène suivi d'un nettoyage par voie humide.

Alternativement, comme les bases des plots 120 du substrat temporaire 100 n'ont pas été exposées au composé hydrophobe, elles sont toujours compatibles avec un collage direct. Le substrat temporaire 100 peut donc être directement réutilisé.

A l'issue du procédé, on obtient un substrat 200 ayant une première surface 201 comprenant des zones hydrophiles Z1 entourées par des zones hydrophobes Z2 (figures 2 et 3). Chaque zone hydrophile Z1 est entourée par une zone hydrophobe Z2.

Les zones hydrophiles Z1 ont, par exemple, une surface comprise entre 0,25 et 400 mm².

Les zones hydrophobes Z2 sont des zones recouvertes par une couche hydrophobe ou des zones d'un matériau hydrophobe mis à nu par gravure chimique.

Les zones hydrophobes Z2 ont, de préférence, une largeur comprise entre 10 µm et 2,5 mm. Pour un substrat sur lequel les puces seront collées de manière collective, la largeur des zones hydrophobes est, par exemple, comprise entre 400 µm et 2,5 mm. Pour un substrat sur lequel les puces seront collées de manière individuelle, la largeur des zones hydrophobes est, par exemple, comprise entre 10 µm et 2,5 mm, voire entre 40 µm et 2,5 mm. En effet, le placement individuel de puces est en général bien plus précis que le placement collectif.

Des lignes hydrophobes Z3 relient les zones hydrophobes Z2 au bord du substrat 200.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

### Exemples illustratifs et non limitatifs de différents modes de réalisation

### Exemple 1 :

Sur une plaquette de silicium de 200 mm de diamètre, un procédé de photolithographie/gravure permet de former des plots de 10 x 10 mm² ayant une épaisseur de 1 µm ainsi que des éléments linéaires en relief, destinés à former les interstices après collage permettant d'amener/distribuer le liquide vers les zones à rendre hydrophobes, et un élément annulaire en relief autour de la plaque.

Un deuxième procédé de photolithographie/gravure permet de graver l'ensemble de la surface et de former les zones à grand gap en gravant, par exemple, 100pm de silicium en protégeant les zones à petit gap ainsi que les plots d'intérêt. Les zones à petits gaps ont une largeur de 2,5 mm. On réalise un détourage du bord de la plaquette à la scie diamantée d'une largeur de 3 mm et d'une profondeur de 200 µm. Ce détourage est moins large que l'élément annulaire en relief qui subsiste donc après cette étape.

La surface de la plaque temporaire est nettoyée par un plasma O₂ suivi d'un nettoyage qui favorise le mouillage de la surface des plots par la solution. La surface est ainsi également compatible avec un procédé de collage direct. Le nettoyage peut être, par exemple, réalisé par voie humide CARO, SC1.

Une plaquette SOI d'intérêt présente un film de silicium de 205 nm et une couche d'oxyde enterrée de 400 nm. Elle subit un nettoyage par voie humide CARO/SC1 de façon à la rendre compatible avec un procédé de collage direct.

On colle directement le substrat d'intérêt et le substrat temporaire.

Puis, l'assemblage est immergé dans une solution comprenant le composé fluoré Novec^{™} 1720 EGC commercialisé par la société 3M^{™}. Lors de cette immersion, la solution va pénétrer préférentiellement par et le long des zones à faible gap. Une activation ultrasonique peut être réalisée. L'assemblage est ensuite séché par centrifugation.

On démonte le substrat temporaire en insérant un coin dans la structure. On obtient une plaque d'intérêt en silicium qui présente des zones de 10*10mm² hydrophiles entourés de zones hydrophobes d'une largeur correspondant à la largeur des zones des petits gaps (2,5mm).

### Exemple 2 :

Sur une plaquette temporaire de silicium de 200mm de diamètre, un procédé de photolithographie/gravure permet de former des plots de 11 x 11 mm² ayant une épaisseur de 1 µm ainsi que des éléments en relief (lignes) permettant d'amener le liquide depuis le bord de la plaque et de le distribuer vers les plots et un élément en relief annulaire (anneau) autour de la plaque.

Un deuxième procédé de photolithographie/gravure permet de graver l'ensemble de la surface et de former les zones à grand gap en gravant par exemple 100 µm de silicium en protégeant les zones à petit gap ainsi que les plots d'intérêt. La largeur des zones à petits gap est de 2,5 mm. On réalise un détourage du bord de la plaque temporaire à la scie diamantée d'une largeur de 3 mm et d'une profondeur de 200 µm.

La surface de la plaquette est nettoyée par un plasma O₂ suivi d'un nettoyage par voie humide CARO, SC1 de façon à la rendre hydrophile et ainsi faciliter son mouillage par la solution d'intérêt. Le substrat temporaire est ainsi compatible avec un procédé de collage direct.

Une plaquette SOI d'intérêt présente un film de silicium de 205 nm et une couche d'oxyde enterré de 400 nm. Cette plaquette subit un procédé de photolithographie/gravure permet de former des plots de 10 x 10 mm² et de 1 µm d'épaisseur. Ensuite, un nettoyage par voie humide CARO/SC1 permet de rendre compatible la surface de ces plots avec un procédé de collage direct.

On colle directement les deux substrats en alignant les plots du substrat d'intérêt et du substrat temporaire. Une solution comprenant le composé fluoré Optool commercialisé par la société DAIKIN est alors amenée localement par un tuyau à l'embouchure d'une zone à faible gap. Lors de ce contact, le liquide va pénétrer préférentiellement par et le long des zones à faible gap. Puis l'assemblage est séché par centrifugation. Avantageusement, ici les faces arrière des deux substrats ne sont pas du tout contaminées par le liquide Optool.

On démonte la plaque temporaire en insérant un coin dans la structure. On obtient une plaque d'intérêt en silicium qui présente des plots de 10*10mm² hydrophiles entourés de zones hydrophobes d'une largeur correspondant à la largeur des zones des petits gaps.

### Exemple 3 :

Sur une plaquette temporaire de silicium de 200 mm de diamètre, un procédé de photolithographie/gravure permet de former, dans un premier temps, les lignes de distribution et non les plots. Les lignes permettent d'amener le liquide depuis le bord de la plaque et de le distribuer vers les plots avec une gravure de 1 µm. Un anneau de distribution autour de la plaque est aussi créé.

Un deuxième procédé photolithographie/gravure permet de former des plots de 11 x 11 mm² et d'une épaisseur de 5 µm.

Un troisième procédé de photolithographie / gravure permet de graver l'ensemble de la surface et de former les zones à grand gap en gravant par exemple 100pm de silicium en protégeant les zones à petit gap ainsi que les plots d'intérêt. On réalise un détourage du bord du substrat temporaire à la scie diamantée d'une largeur de 3 mm et d'une profondeur de 200 µm.

La surface de la plaquette temporaire est nettoyée par un plasma O₂ suivi d'un nettoyage par voie humide CARO, SC1 de façon à la rendre hydrophile et ainsi faciliter le mouillage du substrat avec la solution d'intérêt. Le substrat est ainsi compatible avec un procédé de collage direct. Les différentes hauteurs de gravure permettent d'avoir différentes vitesses de pénétration.

Une plaquette SOI d'intérêt présente un film de silicium de 205 nm et une couche d'oxyde enterré de 400 nm. Elle subit un procédé de photolithographie/gravure pour former des plots de 10 x 10 mm² et de 1µm d'épaisseur. Ensuite un nettoyage par voie humide CARO/SC1 permet de rendre compatible avec un procédé de collage direct la surface de ces plots.

On colle directement le substrat temporaire et le substrat d'intérêt en alignant les plots des deux substrats. L'assemblage est seulement sur une petite portion de l'ensemble en faisant attention qu'une zone, au moins, à faible gap touche et souvent pénètre dans le liquide. Le liquide est une solution comprenant le composé fluoré Optool commercialisé par la société DAIKIN. Puis, l'ensemble est séché par centrifugation. Lors de ce trempage, le liquide va pénétrer préférentiellement par et le long des zones à faible gap. Le liquide ira plus vite le long des zones de petits gaps qui entourent les plots d'intérêt ce qui permet de rapidement distribuer le liquide autour des plots qui s'entourent ensuite plus lentement. Dans cet exemple la majorité de la surface des faces arrière des deux substrats n'a pas vu le liquide et n'aura donc pas besoin d'être nettoyée.

On démonte la plaque temporaire en insérant un coin dans la structure. On obtient une plaque d'intérêt de silicium qui présente des plots de 10*10mm² hydrophiles entourés de zones hydrophobes d'une largeur correspondant à la largeur des zones des petits gaps.

## Revendications

1. Procédé de formation de zones hydrophobes (Z2, Z3) sur un substrat d'intérêt (200), le procédé comprenant les étapes suivantes :
- fournir le substrat d'intérêt (200) comprenant une première surface (201) hydrophile et un substrat temporaire (100) comprenant un substrat de base (110) recouvert localement de plots (120) et d'éléments en relief (130, 140) ayant une hauteur inférieure à la hauteur des plots (120), une première partie des éléments en relief étant des éléments périphériques (130) entourant les plots (120) et une deuxième partie des éléments en relief étant des éléments de connexion fluidique (140) allant des éléments périphériques (130) jusqu'au bord du substrat temporaire (200),
- coller les plots (120) du substrat temporaire (100) sur la première surface (201) hydrophile du substrat d'intérêt (200), moyennant quoi le substrat d'intérêt (200) est séparé, d'une part, des éléments en relief (130, 140) par des interstices et, d'autre part, du substrat de base (110) du substrat temporaire (100) par des zones de grands gaps,
- mettre en contact le substrat d'intérêt (200) avec une solution (300) comprenant un composé hydrophobe ou un agent de gravure, moyennant quoi la solution (300) s'infiltre dans les interstices par capillarité et des zones hydrophobes (Z2, Z3) sont formées sur le substrat d'intérêt (200) en regard des éléments en relief (130, 140),
- séparer le substrat d'intérêt (200) du substrat temporaire (100).

2. Procédé selon la revendication 1, **caractérisé en ce que** les interstices ont une hauteur représentant moins de 50% et, de préférence, moins de 10% de la hauteur des zones de grands gaps.

3. Procédé selon l'une des revendications précédentes, **caractérisé en ce que** les interstices ont une hauteur comprise entre 0,1 et 10 µm, de préférence entre 1 et 5 µm.

4. Procédé selon l'une quelconque des revendications précédentes, **caractérisé en ce que** les plots (120) ont une hauteur comprise entre 10 et 100 µm.

5. Procédé selon l'une quelconque des revendications 1 à 4, **caractérisé en ce que** les éléments de connexion fluidique (140) forment un pourtour sur le substrat de base (110).

6. Procédé selon l'une quelconque des revendications 1 à 4, **caractérisé en ce que** les éléments de connexion fluidique (140) sont positionnés de manière discontinue sur le pourtour du substrat de base (110), de manière à former des évents entre les éléments de connexion fluidique (140).

7. Procédé selon l'une quelconque des revendications précédentes, **caractérisé en ce que** les éléments en relief (130, 140) ont une largeur comprise entre 10 µm et 2,5 mm.

8. Procédé selon l'une quelconque des revendications précédentes, **caractérisé en ce que** les plots (120) ont une surface comprise entre 0,25 et 400 mm².

9. Procédé selon l'une quelconque des revendications précédentes, **caractérisé en ce que** le substrat (200) comprend des zones (Z1) de plus fortes topographies et/ou d'interconnexions métalliques, sur lesquelles sont collés les plots (120).

10. Procédé selon l'une quelconque des revendications précédentes, **caractérisé en ce que** seul un bord du substrat d'intérêt (200) est mis en contact avec la solution (300), au niveau d'un élément de connexion fluidique (140).

11. Procédé selon l'une quelconque des revendications précédentes, dans lequel le substrat de base (110), les plots (120) et les éléments en relief (130, 140) sont en un même matériau.

12. Substrat (200) ayant une première surface (201) comprenant des zones hydrophiles (Z1) entourées par des zones hydrophobes (Z2), ayant de préférence une largeur comprise entre 10 µm et 2,5 mm, des lignes hydrophobes (Z3) reliant les zones hydrophobes (Z2) au bord du substrat (200).
